(19) Europäisches Patentamt
European Patent Office
Office européen des brevets

(11) **EP 0 901 682 B1**

(12) **EUROPÄISCHE PATENTSCHRIFT**

(45) Veröffentlichungstag und Bekanntmachung des Hinweises auf die Patenterteilung:
**29.08.2001   Patentblatt 2001/35**

(51) Int Cl.[7]: **G11C 11/409**

(86) Internationale Anmeldenummer:
**PCT/DE97/01027**

(21) Anmeldenummer: **97930296.5**

(22) Anmeldetag: **21.05.1997**

(87) Internationale Veröffentlichungsnummer:
**WO 97/47010 (11.12.1997 Gazette 1997/53)**

(54) **LESEVERSTÄRKER FÜR HALBLEITERSPEICHERZELLEN MIT EINER EINRICHTUNG ZUR KOMPENSATION VON SCHWELLENSPANNUNGSUNTERSCHIEDEN BEI DEN LESEVERSTÄRKERTRANSISTOREN**

READ AMPLIFIER FOR SEMICONDUCTOR MEMORY CELLS WITH MEANS TO COMPENSATE THRESHOLD VOLTAGE DIFFERENCES IN READ AMPLIFIER TRANSISTORS

AMPLIFICATEUR DE LECTURE POUR CELLULES DE MEMOIRE A SEMI-CONDUCTEUR, AVEC DISPOSITIF DE COMPENSATION DE DIFFERENCES DE TENSIONS DE SEUIL DANS LES TRANSISTORS AMPLIFICATEURS DE LECTURE

(84) Benannte Vertragsstaaten:
**AT DE FR GB IE IT NL**

(30) Priorität: **30.05.1996   DE 19621769**

(43) Veröffentlichungstag der Anmeldung:
**17.03.1999   Patentblatt 1999/11**

(73) Patentinhaber: **Infineon Technologies AG
81669 München (DE)**

(72) Erfinder:
• **KOPLEY, Thomas
Los Altos Hills, CA 94022 (US)**
• **WEBER, Werner
D-80637 München (DE)**
• **THEWES, Roland
D-82194 Gröbenzell (DE)**

(74) Vertreter: **Zedlitz, Peter, Dipl.-Inf. et al
Patentanwalt,
Postfach 22 13 17
80503 München (DE)**

(56) Entgegenhaltungen:
**WO-A-80/01730            WO-A-92/05557**

**Beschreibung**

Aus der europäischen Patentschrift 0 549 623 B1 bzw. aus der korrespondierenden US-Patentschrift 5,333,121 ist ein Leseverstärker nach dem Oberbegriff von Patentanspruch 1 bekannt.

Bei den künftigen DRAM-Speichergenerationen mit einer Speicherkapazität von 1Gbit und mehr werden Probleme mit dem Mismatch von Transistoren in erheblichem Maße zunehmen. Dabei kommen im Prinzip Variationen in der Einsatzspannung und im Drainstrom in Frage, wobei die ersteren ca. 65 bis 100 Prozent des Gesamteffektes ausmachen. Die Einsatzspannungsvariationen sind proportional $\dfrac{1}{\sqrt{Gatefläche}}$ und nehmen folglich mit abnehmenden Transistorflächen zu. Das Maß an Übereinstimmung zweier Transistoren, wie es in Leseverstärkern gefordert wird, wird also mit fortschreitender Miniaturisierung notwendigerweise immer schlechter. Bisher wurde das Problem in erster Linie durch Flächenvergrößerung der im Leseverstärker vorhandenen kreuzgekoppelten Transistoren gelöst. Diese Vorgehensweise findet vermutlich spätestens beim 4 Gbit Speicher ihr Ende, weil dort die notwendige Fläche für das kreuzgekoppelte Transistorpaar des Leseverstärkers nur aufgrund des Mismatchproblems 25 Prozent der gesamten Chipfläche übersteigt.

Aus dem IEEE Journal of Solid-State Circuits, Vol. SC-14, No. 6, December 1979, Seiten 1066 bis 1070, ist ein Leseverstärker bekannt, der eine Einrichtung zur Kompensation von Schwellwertspannungsunterschieden mit vier MOS-Transistoren aufweist. Diese Schaltung hat jedoch beispielsweise den Nachteil, daß ihre Kompensationswirkung von einem Verhältnis schaltungsinterner Käpazitäten abhängt und unvollständig bleibt.

Aus der IEEE-Veröffentlichung IDEM 1981, pp. 44 - 47 ist ein Leseverstärker bekannt, der einen zusätzlichen Transistor zum Gleichsetzen der Bitleitungen und eine zusätzliche Verbindungsleitung zur Versorgungsspannung benötigt.

Die der Erfindung zugrundeliegende Aufgabe besteht nun darin, einen Halbleiterspeicher mit einem Leseverstärker anzugeben, bei dem die obengenannten Nachteile vermieden werden. Dies wird erfindungsgemäß durch die Merkmale des Patentanspruchs 1 gelöst.

Ein besonderer Vorteil der Erfindung besteht darin, daß die vier zusätzlichen Transistoren durch eine entsprechende Ansteuerung auch als Gleichsetzeinrichtung (Equalize) für die beiden Bitleitungen verwendet werden können und somit lediglich ein zusätzlicher Transistor gegenüber konventionellen Leseverstärkern nötig ist.

Weitere Ausgestaltungen der Erfindung ergeben sich aus den Ansprüchen 2 bis 4.

Die Erfindung wird nachfolgend anhand der Zeichnungen näher erläutert. Dabei zeigt

Figur 1 ein Schaltbild einer ersten Ausgestaltung der Erfindung,

Figur 2 ein Zeitdiagramm der in Figur 1 verwendeten Signale,

Figur 3 ein Schaltbild einer zweiten Ausgestaltung der Erfindung und

Figur 4 ein Zeitdiagramm der in Figur 3 verwendeten Signale.

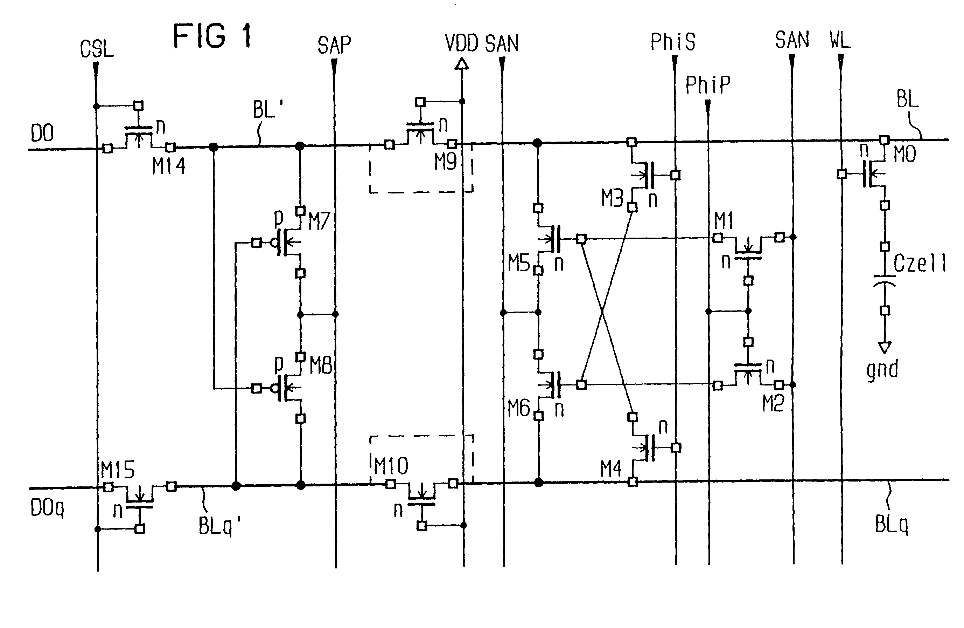

In Figur 1 ist ein erfindungsgemäßer Leseverstärker dargestellt, der mit einem aus den Bitleitungen BL und Blq bestehenden Bitleitungspaar verbunden ist und der sowohl einen sogenannten SAP-Teil als auch einen sogenannten SAN-Teil aufweist. Die Bitleitungen BL' und Blq' des SAP-Teils und die Bitleitungen BL und Blq des SAN-Teils sind dabei entweder, gestrichelt angedeutet, direkt oder aber über in die Bitleitungen eingefügte als Widerstände geschaltete MOS-Transistoren M9 und M10 miteinander verbunden, wobei die Gateanschlüsse der Transistoren M9 und M10 beispielsweise mit der Versorgungsspannung VDD beschaltet sind. Das Bitleitungspaar des SAP-Teils ist beispielsweise über MOS-Transistoren M14 und M15 abhängig von einem Spaltenauswahlsignal CSL an den Gates dieser beiden Transistoren auf ein Datenleitungspaar D0 und D0q durchschaltbar. Die Bitleitung BL des SAN-Teils des erfindungsgemäßen Leseverstärkers ist mit der Speicherzelle verbunden, wobei die Bitleitung BL mit einem ersten Anschluß eines Zellentransistors M0 verbunden ist, dessen Gate mit einer Wortleitung WL beschaltet ist und dessen zweiter Anschluß über einen Zellenkondensator $C_{zell}$ auf Bezugspotential gnd gelegt ist. Der SAP-Teil des Leseverstärkers weist zwei kreuzgekoppelte p-Kanal-MOS-Transistoren M7 und M8 auf, wobei ein erster Anschluß des Transistors M7 mit der Bitleitung BL', der Gateanschluß des Transistors M7 mit der Bitleitung Blq' und der zweite Anschluß des Transistors M7 mit einem ersten Anschluß des Transistors M8 verbunden sind, dessen Gateanschluß mit der Bitleitung BL' des SAP-Bitleitungspaares und dessen zweiter Anschluß mit der Bitleitung Blq' verbunden sind. Dem Verbindungsknoten zwischen den beiden Transistoren M7 und M8 wird ein SAP-Aktivierungssignal SAP zugeführt. Der SAN-Teil des erfindungsgemäßen Leseverstärkers weist zwei kreuzgekoppelte n-Kanal-MOS-Transistoren M5 und M6 auf, wobei ein erster Anschluß des Transistors M5 mit der Bitleitung BL der Gateanschluß des Transistors M5 über einen weiteren n-Kanal-MOS-Transistor M4 mit der Bitleitung Blq und der zweite Anschluß mit einem ersten Anschluß des Transistors M6 verbunden ist, dessen Gateanschluß über einen zweiten weiteren Transistör M3 mit der Bitleitung BL und dessen zweiter Anschluß mit der Bitleitung Blq verbunden ist. Die Gates der Transistoren M3 und M4 sind mit einer ersten Steuerleitung PhiS verbunden und dem Verbindungsknoten der beiden Transistoren M5 und M6 wird ein SAN-Aktivierungssignal SAN zugeführt. Über einen ersten zusätzlichen n-Kanal-MOS-Transistor M1 ist das SAN-Aktivierungssignal auf das Gate des Transistors M5 und über einen zweiten zusätzlichen n-Kanal-MOS-Transistor M2 ist das SAN-Aktivierungssignal dem Gate des Transistors M6 zuführbar, wobei die Gates der Transistoren M1 und M2 mit der Steuerleitung PhiP verbunden sind.

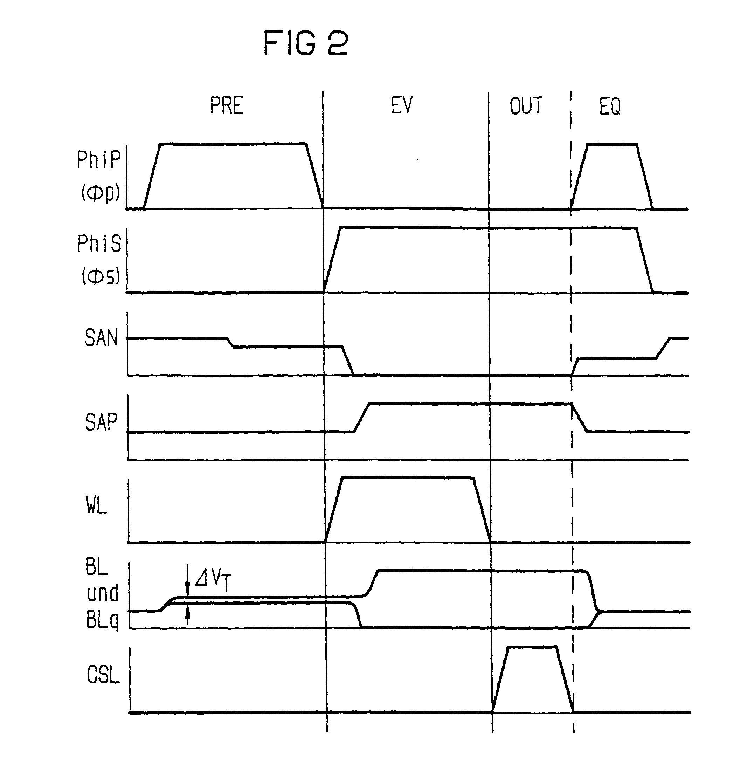

In Figur 2 ist ein Zeitdiagramm für die Steuersignale PhiP und PhiS, die Aktivierungssignale SAN und SAP, das Signal auf der Wortleitung WL, die Signale des Bitleitungspaares BL und Blq sowie des Spaltenauswahlsignals CSL während einer Vorladephase PRE, einer Bewertungsphase EV, einer Ausgabephase OUT und einer Gleichsetzphase EQ dargestellt. Während der Vorladephase PRE und der Gleichsetzphase, bei der die Bitleitungen des Bitleitungspaares auf gleiches Potential gelegt werden, weist das Steuersignal PhiP High-Potential und sonst Low-Potential auf. Das Steuersignal PhiS weist bis auf die Vorladephase PRE High-Potential auf. Das SAN-Aktivierungssignal fällt in Stufen innerhalb der Vorladephase und zu Beginn der Bewertungsphase bis auf Low-Potential ab und steigt innerhalb der Gleichsetzphase EQ in Stufen wieder auf High-Potential. Das SAP-Aktivierungssignal weist innerhalb der Vorladephase und am Anfang der Bewertungsphase, bis das SAN-Aktivierungssignal auf Low-Potential liegt, einen mittleren Pegel von beispielsweise VDD/2 auf und weist den restlichen Teil der Bewertungsphase EV und währendder Ausgabephase den High-Pegel auf und fällt innerhalb der Gleichsetzphase EQ wieder auf den mittleren Pegel VDD/2 ab. Die Wortleitung WL erhält lediglich innerhalb der Bewertungsphase EV High-Pegel und weist sonst Low-Pegel auf. Die Pegel der Bitleitungen BL und BLq führen innerhalb der Vorladephase und zum Beginn der Bewertungsphase, nach dem das Steuersignal PhiP High-Pegel aufweist, annähernd VDD/2 und unterscheiden sich aufgrund des Transistor-Mismatch um die Schwellenspannungsdifferenz $\Delta V_T$. Innerhalb der weiteren Bewertungsphase und der Ausgangsphase weist die Bitleitung BL High-Pegel und die Bitleitung Blq Low-Pegel auf, wenn die zu bewertende Zelle geladen war. Für den Fall, daß die Zelle ungeladen war, sind die Bitleitungspegel entsprechend vertauscht. Innerhalb der Gleichsetzphase EQ weisen die Bitleitungen BL und Blq gleiches Potential auf. Das Spaltenauswahlsignal CSL ist lediglich in der Ausgabephase OUT auf High-Pegel.

In der Vorladephase PRE weisen die beiden Bitleitungen gleiche Pegel von Null bis maximal VDD/2 - $V_{t,max}$ auf, wobei $V_{t,\ max}$ die maximal mögliche Einsatzspannung der kreuzgekoppelten Transistoren darstellt. Bei ausgeschaltetem Steuersignal PhiS wird nun PhiP auf einen hohen Pegel von zum Beispiel VDD geschaltet, wodurch die beiden Transistoren M1 und M2 leitend werden, während die Transistoren M3 und M4 sperren. Der Pegel des SAN-Auswahlsignals beträgt dabei ca.

VDD/2 + $V_{t,max}$ und wird durch die Transistoren M1 und M2 auf die Gates des kreuzgekoppelten Transistorpaares M5 und M6 geschaltet. Beide Gatepegel sind exakt gleich, da kein Gleichstrom durch die eventuell nicht exakt gleichen Transistoren M1 und M2 fließt. Da durch das SAN-Aktivierungssignal auch der Knoten zwischen den Transistoren M5 und M6 auf das Potential VDD/2 + $V_{t,max}$ geladen wird, stellt sich auf der Bitleitung BL ein Potential von VDD/2 + $V_{t,max}$ - $V_{t,M5}$ und auf der Bitleitung Blq ein Potential von VDD/2 + $V_{t,max}$ - $V_{t,M6}$ ein. Die Spannungsdifferenz $\Delta V_{BL-Blq}$ entspricht dann genau der Differenz der Einsatzspannungen der beiden kreuzgekoppelten Transistoren M5 und M6. Am Ende der Vorladephase PRE wird die Spannung des SAN-Aktivierungssignals um eine mittlere Einsatzspannung der beiden Transistoren M5 und M6 reduziert, wodurch nahezu gleiche Pegel an den Bitleitungen BL und Blq bzw. an den Gates von den Transistoren M5 und M6 erreicht werden. Während der nachfolgenden Bewertung kann so keine Ladung von den beiden Gates der Transistoren M5 und M6 auf die Bitleitungen BL und Blq fließen.

In der Bewertungsphase EV wird das Signal PhiP auf Low-Potential gelegt und das Steuersignal PhiS zum Beispiel auf VDD angehoben, so daß die Transistoren M1 und M2 sperren während die Transistoren M3 und M4 öffnen, wodurch die Kreuzkopplung eingeschaltet wird. Gleichzeitig erhält die Wortleitung WL High-Potential, so daß die Zelladung auf die Bitleitung BL geladen wird. Nach dem Abklingen der Überkopplungen wird zur eigentlichen Bewertung das SAN-Aktivierungssignal auf Low-Potential gelegt und etwas später das SAP-Aktivierungssignal angehoben. Der Vorteil des erfindungsgemäßen Leseverstärkers wird nun im folgenden deutlich. Für den Fall, daß der Transistor M5 eine niedrigere Einsatzspannung als der Transistor M6 aufweist, ist der Pegel am Ende der Vorladephase auf der Bitleitung BL höher als auf der Bitleitung BLq, was jedoch die bessere Leitfähigkeit dieses Transistors während der Bewertungsphase kompensiert. Beispielsweise führt ein Mismatch von 175 Milli-Volt in den Einsatzspannungen der Transistoren M5 und M6 immer noch zu einer korrekten Bewertung, während mit bekannten Leseverstärkern keine korrekte Bewertung mehr erreicht wird.

In der Datenausgabe und Gleichsetzphase wird die Wortleitung WL wieder abgeschaltet und anschließend mit Hilfe des Spaltenauswahlsignals CSL das Datum ausgelesen. Danach wird bei bereits auf High-Potential befindlichem Steuersignal PhiS das Steuersignal PhiP angehoben, um die Pegel der Bitleitungen BL und Blq auszugleichen und auf einen Wert des SAN-Aktivierungssignals, der zwischen 0 Volt und maximal VDD/2 + $V_{t,max}$ liegt, einzustellen. Auf diese Weise wird der ursprüngliche Zustand wieder hergestellt.

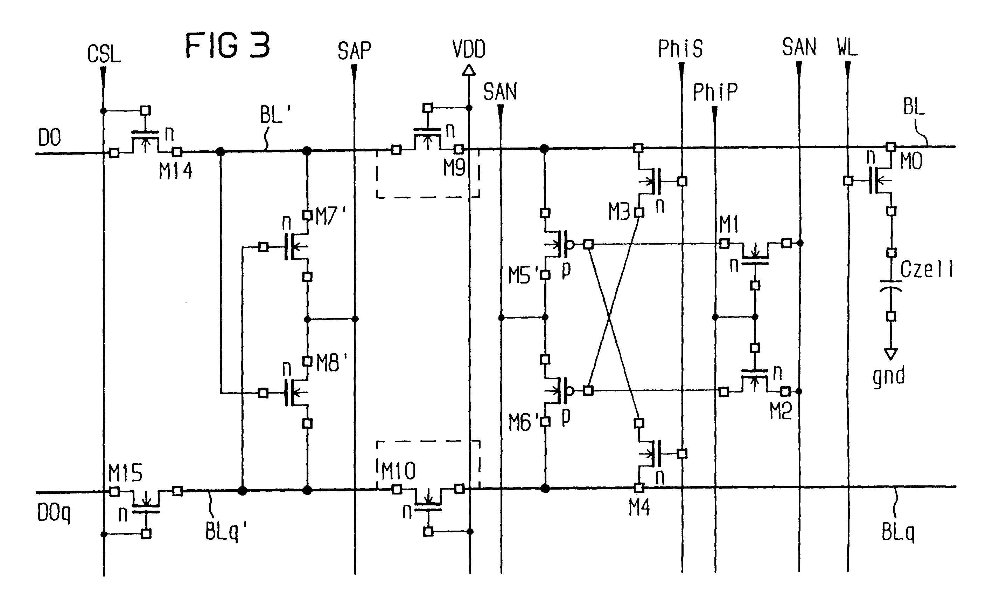

In Figur 3 ist eine weitere Ausgestaltung des erfinderischen Leseverstärkers dargestellt bei der die n-Kanal-Transistoren M5 und M6 durch p-Kanal-Transistoren M5' und M6' sowie die p-Kanal-Transistoren M7 und M8 durch n-Kanal-Transistoren M7' und M8' ersetzt sind und die SAN und SAP-Aktivierungsleitungen miteinander vertauscht sind. Die Transistoren M1 bis M4 sind weiterhin n-Kanal-MOS-Transistoren, da diese eine bessere Leitfähigkeit aufweisen.

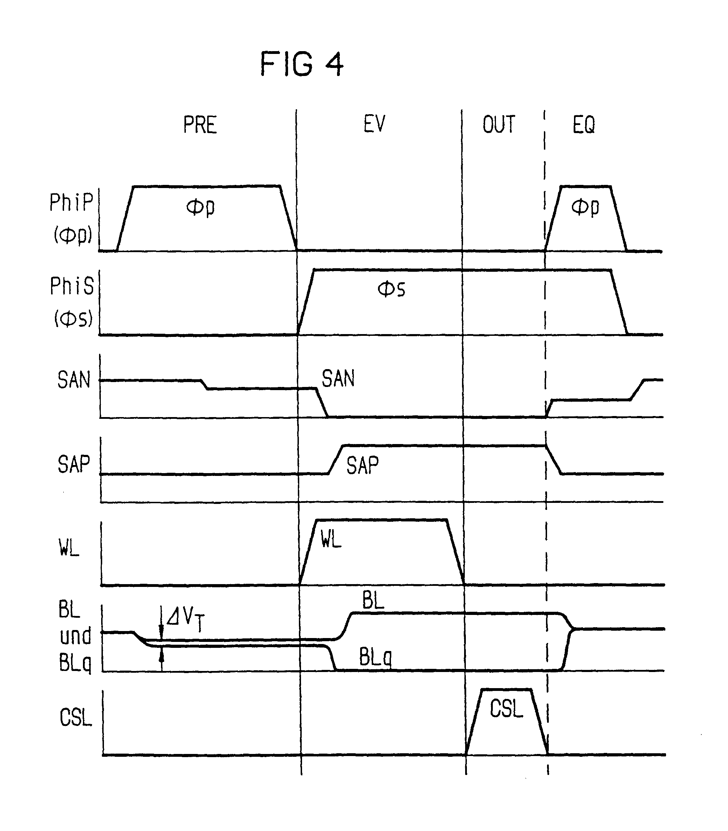

In Figur 4 ist das zur Figur 3 gehörige Zeitdiagramm dargestellt und weist nur bei den SAN- und SAP-Aktivierungssignalen und bei den Pegeln der Bitleitungen gegenüber den Signalverläufen von Figur 2 Unterschiede auf. Hierbei fällt auf, daß innerhalb der Vorladephase PRE kein stufenförmiger Abfall des SAN-Aktivierungssignals jedoch beim SAP-Aktivierungssignal ein stufenförmiger Verlauf auftritt, der zum Verlauf des SAN-Aktivierungssignales in Fig. 2 spiegelbildlich ist. Innerhalb der Vorladephase PRE unterscheiden sich die Spannungen der Bitleitungen BL und BLq wiederum um $\Delta V_T$ und lediglich die Pegel der Bitleitungen sind niedriger in dem Zustand in dem das Steuersignal PhiP high ist als in dem Zustand in dem das Steuersignal PhiP noch low ist und in der Gleichsetzphase EQ ergibt sich ein höherer gemeinsamer Pegel als bei Figur 2.

## Patentansprüche

1. Halbleiterspeicher mit einem Leseverstärker,

   - der mit einem Bitleitungspaar (BL, Blq) verbunden ist, wobei eine erste Bitleitung (BL) des Bitleitungspaares mit einer Speicherzelle (M0, $C_{zell}$) beschaltet ist und eine zweite Bitleitung (BLq) eine Vergleichsleitung darstellt,
   - der zwei kreuzgekoppelte MOS-Transistoren (M5, M6) aufweist, die ein Halteglied bilden, wobei diese MOS-Transistoren jeweils einen ersten Anschluß aufweisen, der mit einem Aktivierungseingang (SAN) des Leseverstärkers verbunden ist und wobei ein zweiter Anschluß eines ersten (M5) dieser beiden MOS-Transistoren mit der ersten Bitleitung (BL) und ein zweiter Anschluß eines zweiten (M6) dieser beiden MOS-Transistoren mit der zweiten Bitleitung (BLq) verbunden sind, und
   - der zwei zusätzliche MOS-Transistoren (M1, M2) aufweist, wobei die Gates dieser Transistoren mit einer ersten Steuerleitung (PhiP) verbunden sind und wobei je ein erster Anschluß dieser beiden zusätzlichen MOS-Transistoren mit je einem der Gates der kreuzgekoppelten MOS-Transistoren verbunden sind,

   **dadurch gekennzeichnet**,

   - daß das Gate des ersten (M5) der kreuzgekoppelten MOS-Transistoren über einen ersten weiteren MOS-Transistor (M4) mit der zweiten Bitleitung (BLq) und das Gate des zweiten (M6) kreuzgekoppelten MOS-Transistors über einen zweiten weiteren MOS-Transistor (M3) mit der ersten Bitleitung (BL) verbindbar sind, wobei die Gates der beiden weiteren MOS-Transistoren gemeinsam mit einer zweiten Steuerleitung (PhiS) beschaltet sind, und
   - daß die zusätzlichen MOS-Transistoren (M1, M2) zweite Anschlüsse aufweisen, die gemeinsam mit dem Aktivierungseingang (SAN) des Leseverstärkers verbunden sind.

2. Halbleiterspeicher mit einem Leseverstärker nach Anspruch 1,
   **dadurch gekennzeichnet**,
   daß die beiden zusätzlichen MOS-Transistoren (M1, M2) und die beiden weiteren MOS-Transistoren (M3, M4) alle n-Kanal-MOS-Transistoren sind.

3. Halbleiterspeicher mit einem Leseverstärker nach Anspruch 1 oder Anspruch 2,
   **dadurch gekennzeichnet**,
   daß die beiden kreuzgekoppelten MOS-Transistoren (M5, M6) n-Kanal-MOS-Transistoren sind.

4. Halbleiterspeicher mit einem Leseverstärker nach Anspruch 1 oder Anspruch 2,
   **dadurch gekennzeichnet**,
   daß die beiden kreuzgekoppelten MOS-Transistoren (M5', M6') p-Kanal-MOS-Transistoren sind.

## Claims

1. Semiconductor memory having a sense amplifier,

   - which is connected to a pair of bit lines (BL, Blq), a first bit line (BL) of the pair of bit lines being connected up to a memory cell (M0, $C_{cell}$) and a second bit line (BLq) constituting a comparison line,
   - which has two cross-coupled MOS transistors (M5, M6) which form a holding element, these MOS transistors each having a first terminal which is connected to an activation input (SAN) of the sense amplifier, and a second terminal of a first (M5) of these two MOS transistors being connected to the first bit line (BL) and a second terminal of a second (M6) of these two MOS transistors being connected to the second bit line (BLq), and
   - which has two additional MOS transistors (M1, M2), the gates of these transistors being connected to a first control line (PhiP), and a respective first terminal of these two additional MOS transistors being connected to in each case one of the gates of the cross-coupled MOS transistors,

**characterized**

- in that the gate of the first (M5) of the cross-coupled MOS transistors can be connected via a first further MOS transistor (M4) to the second bit line (BLq) and the gate of the second (M6) cross-coupled MOS transistor can be connected via a second further MOS transistor (M3) to the first bit line (BL), the gates of the two further MOS transistors being jointly connected up to a second control line (PhiS), and
- in that the additional MOS transistors (M1, M2) have second terminals which are jointly connected to the activation input (SAN) of the sense amplifier.

2. Semiconductor memory having a sense amplifier according to Claim 1,
**characterized**
**in that** the two additional MOS transistors (MI, M2) and the two further MOS transistors (M3, M4) are all n-channel MOS transistors.

3. Semiconductor memory having a sense amplifier according to Claim 1 or Claim 2,
**characterized**
**in that** the two cross-coupled MOS transistors (M5, M6) are n-channel MOS transistors.

4. Semiconductor memory having a sense amplifier according to Claim 1 or Claim 2,
**characterized**
**in that** the two cross-coupled MOS transistors (M5', M6') are p-channel MOS transistors.

**Revendications**

1. Mémoire à semiconducteur comportant un amplificateur de lecture,

- qui est relié à une paire (BL, Blq) de lignes de transmission de bits, une première ligne (BL) de transmission de bits de la paire de lignes de transmission de bits étant raccordée à une cellule (M0, $C_{zell}$) de mémoire et une deuxième ligne (Blq) de transmission de bits représentant une ligne de comparaison,
- qui comporte deux transistors (M5, M6) MOS qui sont couplés en croix et qui forment un élément de maintien, ces transistors MOS comportant chacun une première borne qui est reliée à une entrée SAN d'activation de l'amplificateur de lecture et une deuxième borne d'un premier (M5) de ces deux transistors MOS étant reliée à la première ligne (BL) de transmission de bits et une deuxième borne d'un deuxième (M6) de ces deux transistors MOS étant reliée à la deuxième ligne (Blq) de transmission de bits, et
- qui comporte deux transistors (M1, M2) MOS supplémentaires, les grilles de ces transistors étant reliées à une première ligne (PhiP) de commande et chaque fois une première borne de ces deux transistors MOS supplémentaires étant reliée chacune à l'une des grilles des transistors MOS couplés en croix,

**caractérisée en ce que**

- la grille du premier (M5) des transistors MOS couplés en croix peut être reliée par l'intermédiaire d'un premier transistor (M4) MOS supplémentaire à la deuxième ligne (Blq) de transmission de bits et la grille du deuxième (M6) transistor MOS couplé en croix peut être reliée par l'intermédiaire d'un deuxième transistor (M3) MOS supplémentaire à la première ligne (BL) de transmission de bits, les grilles des deux transistors MOS supplémentaires étant connectées en commun à une deuxième ligne (PhiS) de commande, et
- les transistors (M1, M2) MOS supplémentaires comportent des deuxièmes bornes qui sont reliées en commun à l'entrée SAN d'activation de l'amplificateur de lecture.

2. Mémoire à semiconducteur comportant un amplificateur de lecture suivant la revendication 1, **caractérisée en ce que** les deux transistors (M1, M2) MOS supplémentaires et les deux transistors (M3, M4) MOS supplémentaires sont tous des transistors MOS à canal de type de conductivité n.

3. Mémoire à semiconducteur comportant un amplificateur de lecture suivant la revendication 1 ou la revendication 2, **caractérisée en ce que** les deux transistors (M5, M6) MOS couplés en croix sont des transistors MOS à canal de type de conductivité n.

4. Mémoire à semiconducteur comportant un amplificateur de lecture suivant la revendication 1 ou la revendication 2, **caractérisée en ce que** les deux transistors (M5', M6') MOS couplés en croix sont des transistors MOS à canal de type de conductivité p.

# FIG 1

EP 0 901 682 B1

# FIG 2

FIG 3

EP 0 901 682 B1

# FIG 4